# EUROPEAN PATENT APPLICATION

(11) **EP 4 664 441 A1**
(43) Date of publication of application: **17.12.2025**
(21) Application number: 24853452.1
(22) Date of filing: 11.07.2024
(51) Int. Cl.: G09F 9/33

(54) **WIRING SUBSTRATE AND MANUFACTURING METHOD THEREFOR, AND DISPLAY DEVICE**

(30) Priority: 14.08.2023 CN 202311021470
(71) Applicant: Boe Technology Group Co., Ltd., Beijing 100015 (CN); BOE MLED Technology Co., Ltd., Beijing 100176 (CN); Beijing BOE Technology Development Co., Ltd., Beijing 100176 (CN)
(72) Inventor: WANG, Huaimin, Beijing 100176 (CN); LIU, Chao, Beijing 100176 (CN); WANG, Lili, Beijing 100176 (CN); FENG, Shanshan, Beijing 100176 (CN); ZHAO, Jingping, Beijing 100176 (CN); JIA, Mingming, Beijing 100176 (CN); WANG, Jing, Beijing 100176 (CN); LIU, Mengqing, Beijing 100176 (CN); FENG, Sha, Beijing 100176 (CN); ZHAI, Ming, Beijing 100176 (CN); QI, Qi, Beijing 100176 (CN)
(74) Representative: Hoffmann Eitle
(86) International application number: PCT/CN2024/104991
(87) International publication number: WO 2025/036040

(57) **Abstract**

A wiring substrate, comprising a base, a plurality of electrodes, and a plurality of leads. The base has a first surface and a second surface arranged opposite to each other, and a plurality of side surfaces connecting the first surface and the second surface, wherein at least one of the plurality of side surfaces is a selected side surface. The plurality of electrodes are arranged on the first surface of the base at intervals in a first direction, and/or are arranged on the second surface of the base at intervals in the first direction. The plurality of leads are arranged at intervals in the first direction. The plurality of leads comprise a plurality of first leads and a plurality of second leads, at least one electrode is connected to at least two first leads, and the plurality of second leads are insulated from the electrodes. Moreover, on the first surface or the second surface of the base, at least one second lead is arranged between two first leads which are connected to different electrodes and are adjacent to each other.

## Description

This application claims priority to Chinese Patent Application No. 202311021470.1, filed on August 14, 2023, which is incorporated herein by reference in its entirety.

### TECHNICAL FIELD

The present disclosure relates to the field of display technologies, and in particular, to a wiring substrate and a method for manufacturing the same, and a display apparatus.

### BACKGROUND

With the development of light-emitting diode technologies, a light-emitting substrate adopting submillimeter level (mini) light-emitting diodes (LED) or even micrometer level (micro) LEDs has been widely used. Therefore, a product adopting the light-emitting substrate, such as a liquid crystal display (LCD), may have a picture contrast reaching a level of an organic light-emitting diode (OLED) display product, and may also retain the technical advantages of the liquid crystal display. As a result, the display effect of images is improved, and good visual experience is provided for users.

### SUMMARY

In an aspect, a wiring substrate is provided. The wiring substrate includes a substrate, a plurality of electrodes and a plurality of leads. The substrate has a first surface and a second surface that are opposite to each other and a plurality of side surfaces connecting the first surface and the second surface, and at least one side surface among the plurality of side surfaces is a selected side surface. The plurality of electrodes are arranged at intervals in a first direction on the first surface of the substrate and/or are arranged at intervals in the first direction on the second surface of the substrate.

The plurality of leads are arranged at intervals in the first direction. Each lead includes a first line segment, a second line segment and a third line segment that are connected in sequence. The first line segment is located on the first surface, the second line segment is located on the selected side surface, and the third line segment is located on the second surface. The plurality of leads include a plurality of first leads and a plurality of second leads. At least one of the electrodes laps at least two of the first leads. The plurality of second leads are insulated from the electrodes; and on the first surface or the second surface of the substrate, at least one second lead exists between two adjacent first leads connected to different electrodes.

In some embodiments, the plurality of electrodes include: a plurality of first electrodes and a plurality of second electrodes. The plurality of first electrodes are arranged at intervals in the first direction on the first surface of the substrate. The plurality of second electrodes are arranged at intervals in the first direction on the second surface of the substrate and are in one-to-one correspondence with the plurality of first electrodes, and at least one of the first electrodes and a corresponding second electrode are connected through at least two of the first leads.

In some embodiments, an orthographic projection of any one of the first electrodes on the substrate at least partially overlaps with an orthographic projection of a corresponding second electrode on the substrate. The substrate includes a first substrate and a second substrate. The first substrate and the second substrate are arranged fixedly and opposite to each other; the first electrodes are arranged on a surface of the first substrate away from the second substrate; and the second electrodes are arranged on a surface of the second substrate close to or away from the first substrate.

In some embodiments, a first electrode and a second electrode that are connected to a same first lead constitute an electrode pair; a first electrode and a second electrode in any one electrode pair are connected by a first lead group; and each first lead group includes at least two first leads.

In some embodiments, a ratio of a width of the first lead group in the first direction to a width of the electrode pair in the first direction is greater than or equal to 1 and less than or equal to 1.8.

In some embodiments, quantities of first leads included in different first lead groups are the same.

In some embodiments, a quantity of first leads included in any one first lead group is positively correlated with a width, in the first direction, of an electrode pair connected to the any one first lead group.

In some embodiments, widths, in the first direction, of first leads in all first lead groups are the same; and/or a distance between two adjacent first leads in all the first lead groups is the same.

In some embodiments, in each first lead group, a distance between any two adjacent first leads in the first direction is less than or equal to a width of any one first lead in the first direction.

In some embodiments, a distance between any two adjacent leads in the first direction is the same; and/or a width of any one lead in the first direction is the same.

In some embodiments, a distance between any two adjacent leads in the first direction is less than or equal to a width of any one lead in the first direction.

In another aspect, a display apparatus is provided. The display apparatus includes the wiring substrate as described in any one of the above embodiments, electronic components, and a driver circuit board. The electronic components are disposed on the first surface of the substrate of the wiring substrate, and the driver circuit board is connected to the wiring substrate.

In yet another aspect, a method for manufacturing a wiring substrate is provided. The method for manufacturing the wiring substrate is used for manufacturing the wiring substrate as described in any one of the above embodiments. The method includes the following steps.

The substrate is provided. The substrate has a first surface and a second surface that are opposite to each other and a plurality of side surfaces connecting the first surface and the second surface. At least one side surface among the plurality of side surfaces is a selected side surface. The first surface of the substrate is provided with a plurality of electrodes arranged at intervals in a first direction, and/or the second surface of the substrate is provided with a plurality of electrodes arranged at intervals in a first direction.

The plurality of leads are formed. The plurality of leads are arranged at intervals in the first direction; each lead includes a first line segment, a second line segment and a third line segment that are connected in sequence; the first line segment is located on the first surface, the second line segment is located on the selected side surface, and the third line segment is located on the second surface; the plurality of leads include a plurality of first leads and a plurality of second leads; at least one of the electrodes laps at least two of the first leads; the plurality of second leads are insulated from the electrodes; and on the first surface or the second surface of the substrate, at least one second lead exists between two adjacent first leads connected to different electrodes.

In some embodiments, forming the plurality of leads includes: forming a conductive layer, the conductive layer covering the selected side surface of the substrate and extending to the first surface and the second surface; and performing multiple etching processes on specific portions of the conductive layer, where portions of the conductive layer that are not etched form the plurality of leads.

In some embodiments, performing multiple etching processes on the specific portions of the conductive layer includes: performing multiple etching processes on first specific portions of the conductive layer, where portions of the conductive layer that are not etched form a plurality of initial leads; and etching second specific portions of each of the initial leads, where portions of the initial leads that are not etched form the plurality of leads.

In some embodiments, an etching order of performing multiple etching processes includes at least one of: performing multiple etching processes sequentially from one side to another side of the conductive layer, performing multiple etching processes alternately from a middle to two sides of the conductive layer, or performing multiple etching processes alternately from the two sides to the middle of the conductive layer.

### BRIEF DESCRIPTION OF THE DRAWINGS

In order to describe technical solutions in some embodiments of the present disclosure more clearly, the accompanying drawings to be used in some embodiments of the present disclosure will be introduced briefly. However, the accompanying drawings to be described below are merely some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display apparatus, in accordance with some embodiments;
FIG. 2 is a structural diagram of another display apparatus, in accordance with some embodiments;
FIG. 3 is a sectional view taken along the line A-A' in FIG. 1;
FIG. 4 is a partial sectional view of a display apparatus, in accordance with some embodiments;
FIG. 5 is a top view of a light-emitting substrate, in accordance with some embodiments;
FIG. 6 is a circuit diagram of a light-emitting substrate, in accordance with some embodiments;
FIG. 7 is a partial sectional view of a wiring substrate, in accordance with some embodiments;
FIG. 8 is a partial sectional view of another wiring substrate, in accordance with some embodiments;
FIG. 9 is a partial sectional view of yet another wiring substrate, in accordance with some embodiments;
FIG. 10 is a partial sectional view of yet another wiring substrate, in accordance with some embodiments;
FIG. 11 is a diagram showing a connection structure of electrodes and leads in a wiring substrate, in accordance with some embodiments;
FIG. 12 is a diagram showing a connection structure of electrodes and leads in a wiring substrate, in accordance with some other embodiments;
FIG. 13 is a diagram showing a connection structure of electrodes and leads in a wiring substrate, in accordance with yet some other embodiments;
FIG. 14 is a diagram showing a connection structure of electrodes and leads in a wiring substrate, in accordance with yet some other embodiments;
FIG. 15 is a diagram showing a connection structure of electrodes and leads in a wiring substrate, in accordance with yet some other embodiments;
FIGS. 16 to 18 are each a flow diagram of a method for manufacturing a wiring substrate, in accordance with some embodiments;
FIG. 19 is a diagram showing a step of a method for manufacturing a wiring substrate, in accordance with some embodiments;
FIG. 20 is a diagram showing a step of a method for manufacturing a wiring substrate, in accordance with some other embodiments;
FIG. 21 is a diagram showing a step of a method for manufacturing a wiring substrate, in accordance with yet some other embodiments; and
FIG. 22 is a structural diagram of an initial lead in a wiring substrate, in accordance with some embodiments.

### DETAILED DESCRIPTION

The technical solutions in some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described may be included in any one or more embodiments or examples in any suitable manner.

Hereinafter, terms "first" and "second" are used for descriptive purposes only, and are not to be construed as indicating or implying a relative importance or implicitly indicating the number of indicated technical features. Thus, features defined with "first" and "second" may explicitly or implicitly include one or more of the features. In the description of the embodiments of the present disclosure, the term "multiple", "a plurality of" or "the plurality of" means two or more unless otherwise specified.

Some embodiments may be described using the terms "coupled", "connected" and their derivatives. The term "connected" should be understood in a broad sense. For example, the term "connected" may represent a fixed connection, or a detachable connection, or a one-piece connection; alternatively, the term "connected" may represent a direct connection, or an indirect connection through an intermediate medium. The term "coupled", for example, indicates that two or more components are in direct physical or electrical contact. The term "coupled" or "communicatively coupled" may also indicate that two or more components are not in direct contact with each other, but still cooperate or interact with each other. The embodiments disclosed herein are not necessarily limited to the context herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

The phrase "applicable to" or "configured to" used herein has an open and inclusive meaning, which does not exclude devices that are applicable to or configured to perform additional tasks or steps.

In addition, the phrase "based on" used is meant to be open and inclusive, since a process, step, calculation or other action that is "based on" one or more of the stated conditions or values may, in practice, be based on additional conditions or value exceeding those stated.

The term such as "about," "substantially," or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel," "perpendicular," or "equal" as used herein includes a stated condition and a condition similar to the stated condition. A range of the similar condition is within an acceptable deviation range, and the acceptable deviation range is determined by a person of ordinary skill in the art, considering measurement in question and errors associated with measurement of a particular quantity (i.e., the limitations of a measurement system). For example, the term "equal" includes absolute equality and approximate equality, and an acceptable range of deviation of the approximate equality may be that, for example, a difference between the two that are equal is less than or equal to 5% of either of the two.

It will be understood that, when a layer or element is referred to as being on another layer or substrate, it may be that the layer or element is directly on the another layer or substrate, or it may be that intermediate layer(s) exist between the layer or element and the another layer or substrate.

Exemplary embodiments are described herein with reference to sectional views and/or plan views that are schematic illustrations of idealized embodiments. In the drawings, thicknesses of layers and areas of regions are enlarged for clarity. Variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Thus, the regions shown in the accompanying drawings are schematic in nature, and their shapes are not intended to show actual shapes of the regions in a device, and are not intended to limit the scope of the exemplary embodiments.

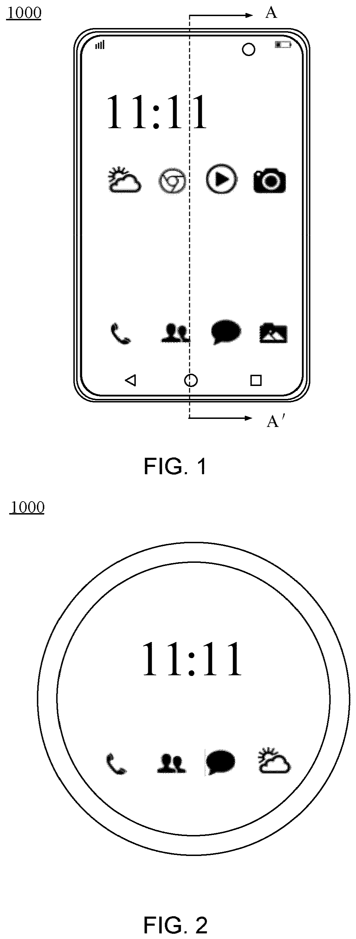

As shown in FIG. 1, some embodiments of the present disclosure provide a display apparatus 1000. The display apparatus 1000 may be any apparatus that displays images whether in motion (e.g., videos) or stationary (e.g., still images), and whether textual or graphical.

For example, referring to FIGS. 1 and 2, the display apparatus 1000 may be any product or component having a display function, such as a television, a notebook computer, a tablet computer, a mobile phone, a personal digital assistant (PDA), a navigator, a wearable device, a virtual reality (VR) device, or the like.

For example, as shown in FIG. 1, the display apparatus 1000 may be a portable display product. For example, the display apparatus 1000 may be a mobile phone shown in FIG. 1. As another example, referring to FIG. 2, the display apparatus 1000 may be a wearable device. For example, the display apparatus 1000 may be a watch shown in FIG. 2.

It will be noted that, depending on different application scenarios, a shape of a display surface of the display apparatus 1000 varies. The shape of the display surface of the display apparatus 1000 may be any one of circle, ellipse or polygon, which is not specifically limited in the embodiments of the present disclosure.

In some embodiments, the display apparatus 1000 may be a liquid crystal display (LCD) apparatus, a mini/micro light-emitting diode (MLED) display apparatus, etc., which is not specifically limited in the embodiments of the present disclosure.

Some embodiments of the present disclosure will be schematically described below by taking an example in which the display apparatus 1000 is a liquid crystal display apparatus. However, the embodiments of the present disclosure are not limited thereto, and any other display apparatuses 1000 may also be taken into consideration as long as the same technical concept is applied.

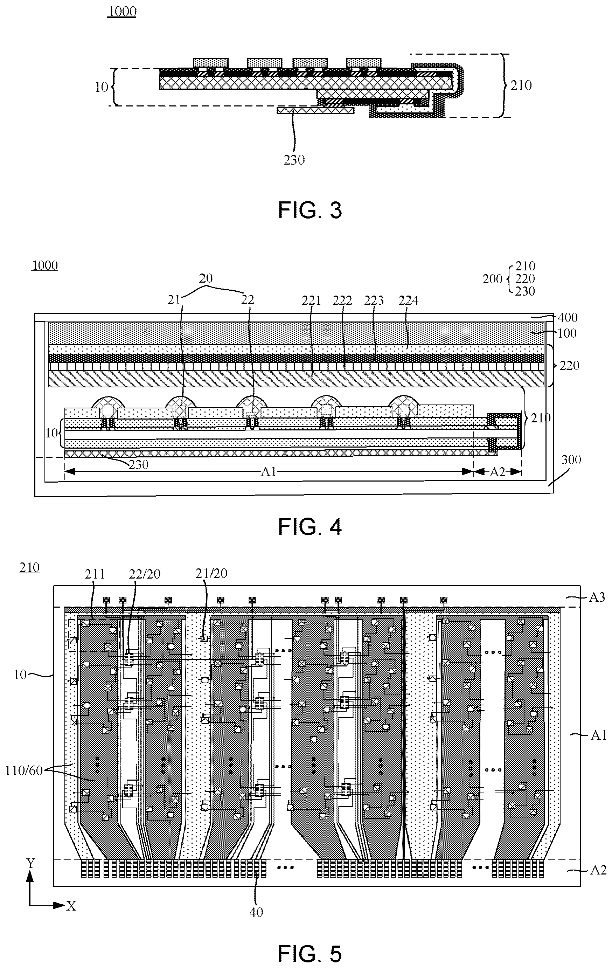

In some embodiments, referring to FIG. 3, the display apparatus 1000 includes a light-emitting substrate 210 and a driver circuit board 230. The light-emitting substrate 210 has a light-emitting side and a non-light-emitting side that are opposite to each other. The light-emitting side is a side of the light-emitting substrate 210 that emits light (an upper side of the light-emitting substrate 210 in FIG. 3), and the non-light-emitting side is another side that is opposite to the light-emitting side (a lower side of the light-emitting substrate 210 in FIG. 3). The driver circuit board 230 is disposed on the non-light-emitting side of the light-emitting substrate 210, and is connected to the light-emitting substrate 210 to provide light-emitting signals to the light-emitting substrate 210. The light-emitting substrate 210 may emit light of only one color, or may emit light of multiple colors. In some examples, the light-emitting substrate 210 is provided with light-emitting devices capable of emitting red light, light-emitting devices capable of emitting green light, and light-emitting devices capable of emitting blue light, and the light-emitting substrate 210 can directly realize full-color display.

In some embodiments, referring to FIG. 4, the display apparatus 1000 includes a display panel 100, a backlight module 200, a housing 300, and a cover plate 400.

As shown in FIG. 4, the display panel 100 includes a display side and a non-display side arranged opposite to each other. The display side refers to a side of the display panel 100 for displaying images (an upper side of the display panel 100 in FIG. 4), and the non-display side is another side opposite to the display side (a lower side of the display panel 100 in FIG. 4). The cover plate 400 is disposed on a light-exit side of the display panel 100, and the cover plate 400 is used for protecting the display panel 100. For example, the cover plate 400 may be made of a rigid material such as glass, quartz, or plastic; alternatively, the cover plate 400 may be made of a flexible material such as polymer resin. The backlight module 200 is disposed on a non-light-exit side of the display panel 100, and the backlight module 200 is used for providing a light source for the display panel 100. The housing 300 may be a box-shaped structure with an opening. The display panel 100 and the backlight module 200 are arranged inside the housing 300. The cover plate 400 is disposed on the light-exit side of the display panel 100 and is located at the opening of the housing 300. The backlight module 200 is disposed on the non-light-exit side of the display panel 100. The backlight module 200 includes the light-emitting substrate 210 and the driver circuit board 230.

In some other examples, the backlight module 200 further includes a plurality of optical films 220. The light-emitting substrate 210 may emit white light directly, and the white light is directed to the display panel 100 after a light uniformizing treatment by the plurality of optical films 220. Alternatively, the light-emitting substrate 210 may emit light of another color (e.g., blue light), which is then directed to the display panel 100 after color conversion and a light uniformizing treatment by the plurality of optical films 220.

For example, referring to FIG. 4, the plurality of optical films 220 include a diffusion plate 221, a quantum dot film 222, a diffusion sheet 223, and a composite film 224 that are arranged in sequence in a direction perpendicular to the light-emitting substrate 210 and away from the light-emitting substrate 210.

The diffusion plate 221 is capable of diffusing light emitted from the light-emitting substrate 210 and providing support for the quantum dot film 222, the diffusion sheet 223, and the composite film 224. The quantum dot film 222 can be excited by light of a certain color emitted from the light-emitting substrate 210 and convert that light into white light to increase the utilization of light energy of the light-emitting substrate 210. The diffusion sheet 223 is capable of homogenizing light passing through the diffusion sheet 223. The composite film 224 is capable of enhancing the light extraction efficiency of the backlight module 200 and improving the display brightness of the display apparatus 1000.

It will be noted that the composite film 224 may include a brightness enhancement film (BEF) and a dual brightness enhancement film (DBEF), utilizing the principles of total reflection, refraction, and polarization to enhance the light flux in a certain angular range, so as to enhance the brightness of the display apparatus 1000.

For example, the light-emitting substrate 210 emits blue light rays in a direction away from the light-emitting substrate 210. The quantum dot film 222 may include a red quantum dot material, a green quantum dot material, and a transparent material. The blue light emitted by the light-emitting substrate 210 is converted to red light when passing through the red quantum dot material; the blue light is converted to green light when passing through the green quantum dot material; the blue light can pass directly through the transparent material; and then, the blue light, the red light, and the green light are mixed and superimposed in a certain ratio to present as white light. Next, the diffusion plate 221 and the diffusion sheet 223 can uniformize the white light, so as to alleviate the light shadow produced by the light-emitting substrate 210 and improve the display picture quality of the display apparatus 1000.

In some embodiments, referring to FIG. 4, the light-emitting substrate 210 includes a wiring substrate 10 and electronic components 20, and the electronic components 20 are disposed on the wiring substrate 10.

As shown in FIGS. 4 and 5, the electronic components 20 may include light-emitting devices 21 and/or microchips 22.

The light-emitting devices 21 may include micro LEDs and/or mini LEDs. For example, a size (e.g., a length) of a micro LED may be less than 50 microns, e.g., in a range of 10 microns to 50 microns. For another example, a size (e.g., a length) of a mini LED is in a range of 50 microns to 150 microns, e.g., in a range of 80 microns to 120 microns.

The microchips 22 may include sensing chips and driver chips. The sensing chip may be, for example, a light-sensitive sensor chip or a thermo-sensitive sensor chip. The driver chip is used to provide driving signals for light-emitting devices 21.

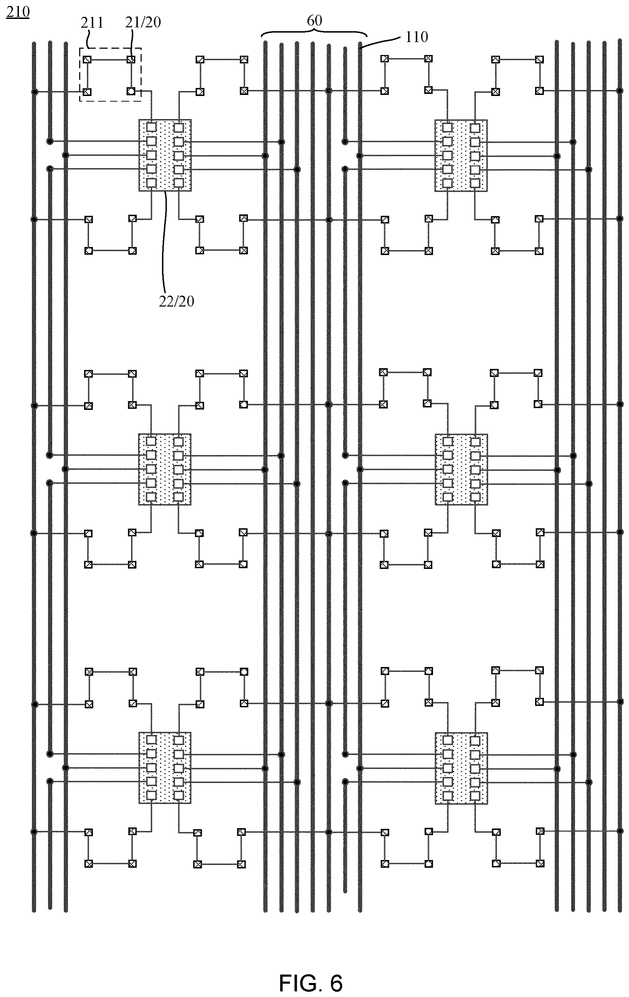

For example, as shown in FIGS. 5 and 6, the light-emitting substrate 210 includes a plurality of driving units 211 arranged in an array, and each driving unit 211 includes multiple light-emitting devices 21 connected in series and/or in parallel.

For example, as shown in FIGS. 5 and 6, each driving unit 211 includes four light-emitting devices 21 sequentially connected in series. Of course, each driving unit 211 may also include three, five, six, or eight light-emitting devices 21, and a connection of multiple light-emitting devices 21 in the driving unit 211 is not limited to a series connection, but may also be a parallel connection, which will not be limited in the embodiments of the present disclosure.

In addition, a single microchip 22 may only drive a plurality of light-emitting devices 21 in one corresponding driving unit 211 to emit light, or it may separately drive a plurality of light-emitting devices 21 in multiple driving units 211 to emit light.

For example, as shown in FIGS. 5 and 6, every four driving units 211 are electrically connected to one microchip 22, and the microchip 22 is electrically connected to a plurality of light-emitting devices 21 in the four driving units 211, so as to separately drive the plurality of light-emitting devices 21 in the four driving units 211 to emit light.

As shown in FIG. 5, the wiring substrate 10 has a light-emitting region A1 and a bonding region A2. In a second direction Y, the bonding region A2 is located on a side of the light-emitting region A1. The light-emitting region A1 is configured to be provided therein with the electronic components 20, and the bonding region A2 is configured to be provided therein with electrodes 40.

In addition, the wiring substrate 10 may further have a test region A3. In a first direction X, the test region A3 is located on a side of the light-emitting region A1 away from the bonding region A2. The test region A3 is configured to be provided therein with test pads.

It will be noted that the electronic components 20 and the electrodes 40 are respectively arranged on two opposite surfaces of the wiring substrate 10, and the test pads may be located on the same surface as the electronic components 20 or located on the same surface as the electrodes 40, which will not be specifically limited in the embodiments of the present disclosure.

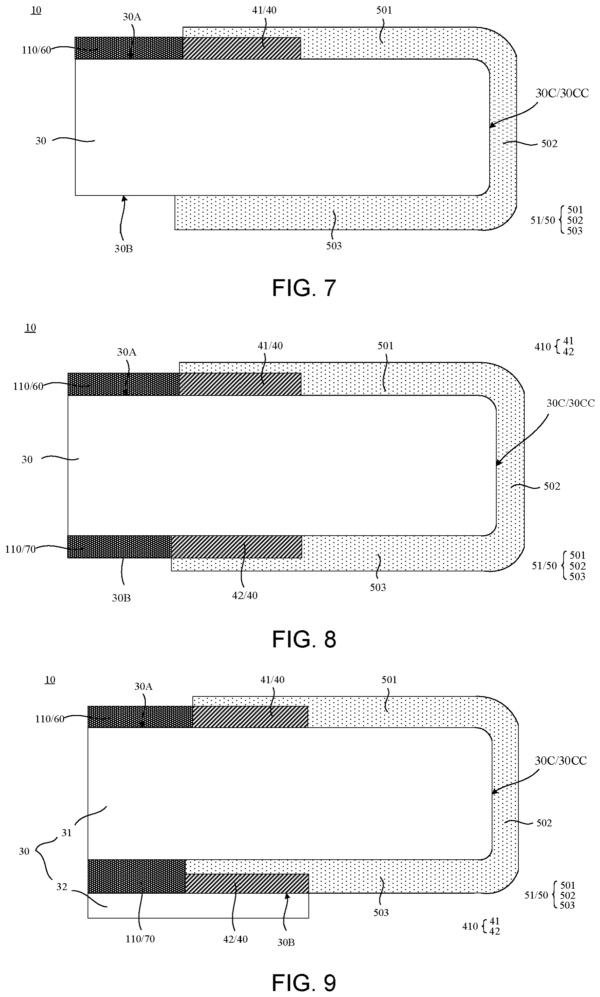

Some embodiments of the present disclosure provide a wiring substrate 10. Referring to FIGS. 7, 8 and 9, the wiring substrate 10 includes a substrate 30, a plurality of electrodes 40, and a plurality of leads 50.

In some examples, as shown in FIGS. 7 to 10, the substrate 30 has a first surface 30A and a second surface 30B that are opposite to each other, and a plurality of side surfaces 30C connecting the first surface 30A and the second surface 30B. At least one side surface among the plurality of side surfaces 30C is a selected side surface 30CC. For example, the selected side surface 30CC is a side surface of the substrate 30 that is away from or close to the test region A3 (see FIG. 5).

It will be noted that, among the first surface 30A and the second surface 30B, one is a surface of the substrate 30 for mounting the electronic components 20, and the other is a surface of the substrate 30 for mounting the driver circuit board 230. For example, the first surface 30A is the surface of the substrate 30 for mounting the electronic components 20, and the second surface 30B is the surface of the substrate 30 for mounting the driver circuit board 230.

In some examples, referring to FIGS. 5 and 7, the first surface 30A is the surface of the substrate 30 for mounting the electronic components 20, and the plurality of electrodes 40 are arranged at intervals in the first direction X and in a region, close to an edge, of the first surface 30A of the substrate 30. Alternatively, the second surface 30B is the surface of the substrate 30 for mounting the electronic components 20, and the plurality of electrodes 40 are arranged at intervals in the first direction X and in a region, close to an edge, of the second surface 30B of the substrate 30.

In some other examples, referring to FIGS. 8 to 10, among the plurality of electrodes 40, a part of electrodes 40 are arranged at intervals in the first direction X and on the first surface 30A of the substrate 30, and another part of electrodes 40 are arranged at intervals in the first direction X and on the second surface 30B of the substrate 30. The region where electrodes 40 on the first surface 30A are located is directly opposite to the region where electrodes 40 on the second surface 30B are located. That is, orthographic projections of the two regions on the first surface 30A or the second surface 30B at least partially overlap.

For example, as shown in FIGS. 8 to 10, the plurality of electrodes 40 include a plurality of first electrodes 41 and a plurality of second electrodes 42. The plurality of first electrodes 41 are arranged at intervals in the first direction X and on the first surface 30A of the substrate 30. The plurality of second electrodes 42 are arranged at intervals in the first direction X and on the second surface 30B of the substrate 30.

In some examples, as shown in FIGS. 7 to 15, a plurality of leads 50 are arranged at intervals in the first direction X. Each lead 50 includes a first line segment 501, a second line segment 502, and a third line segment 503 that are connected in sequence. The first line segment 501 is located on the first surface 30A, the second line segment 502 is located on the selected side surface 30CC, and the third line segment 503 is located on the second surface 30B.

Some embodiments of the present disclosure are schematically described below by taking an example in which the first surface 30A is the surface of the substrate 30 for mounting the electronic components 20 and the second surface 30B is the surface of the substrate 30 for mounting the driver circuit board 230, but the embodiments of the present disclosure are not limited thereto.

In addition, the driver circuit board 230 is connected to the third line segment 503 on the second surface 30B of the wiring substrate 10, so as to provide light-emitting signals to the electronic components 20 disposed on the first surface 30A of the wiring substrate 10. That is, no bending avoidance space is required between the housing 300 and the wiring substrate 10 of the display apparatus 1000, which is conducive to reducing the bezel of the display apparatus 1000.

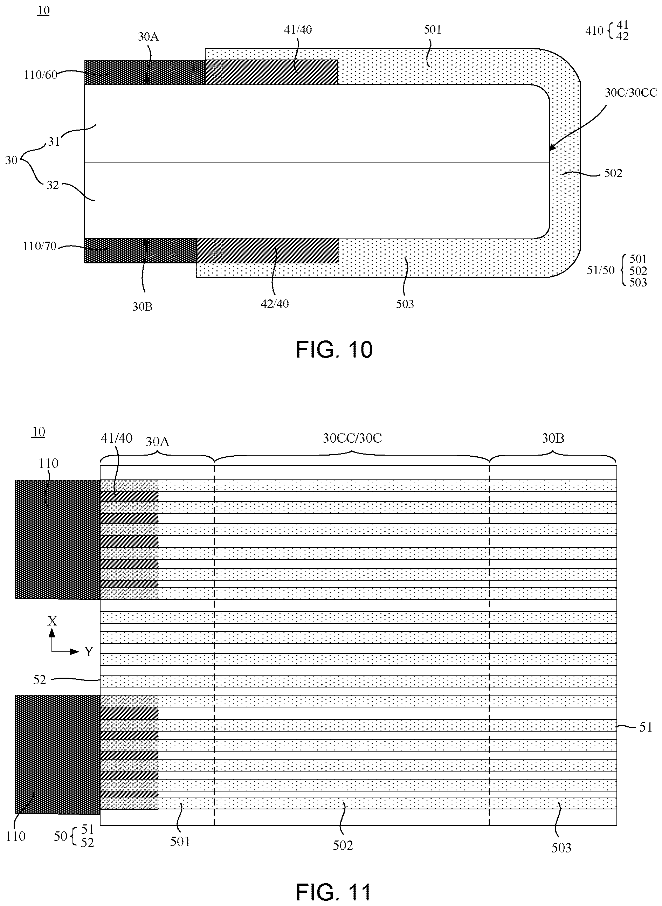

In some examples, as shown in FIGS. 7 and 11, the plurality of leads 50 include a plurality of first leads 51 and a plurality of second leads 52. The electrode 40 laps the first lead 51, and is insulated from all the second leads 52. On the first surface 30A or the second surface 30B of the substrate 30, at least one second lead 52 exists between two adjacent first leads 51 connected to different electrodes 40.

In this case, at least one lead 50 (i.e., the second lead 52) is located between two adjacent first leads 51 connected to different electrodes 40, and the second lead 52 and an adjacent first lead 51 are spaced apart from each other. Each of the plurality of leads 50 extends in the same direction, and the plurality of leads 50 are arranged at intervals in the first direction X. Therefore, the spacing between the plurality of leads 50 may be realized using an etching process, and the spacing may be in a range within 15 µm. In the case where the spacing between the plurality of leads 50 is realized using laser etching, there is a probability of short circuit caused by metal melting and diffusion due to laser etching between two adjacent leads 50. However, since the second lead 52 is arranged between two adjacent first leads 51 connected to different electrodes 40, a probability of short circuit between the two first leads 51 will be greatly reduced. It can be understood that the probability of short circuit will decrease with the increase in the number of second leads 52 arranged between the two first leads 51. Moreover, due to the existence of the second lead 52 and the spacing between adjacent leads, the distance between the two first leads 51 will also become larger, thus further reducing the probability of short circuit between the two first leads 51, and in turn improving the yield and reliability.

The above description that the electrode 40 laps the first lead 51 includes any one of the following cases: the first lead 51 located on a side of the first electrode 41 away from the substrate 30; the first electrode 41 located on a side of the first lead 51 away from the substrate 30; or the first lead 51 in direct contact with an end face of the first electrode 41 (that is, only borders of orthographic projections of the first lead 51 and the first electrode 41 on the first surface 30A overlap).

Next, considering an example in which the first lead 51 is located on the side of the first electrode 41 away from the substrate 30, some embodiments of the present disclosure are schematically described and illustrated with accompanying drawings. However, the embodiments of the present disclosure are not limited thereto.

On this basis, at least one electrode 40 laps at least two first leads 51. In this way, the electrode 40 lapping at least two first leads 51 can still transmit an electrical signal as long as there is one complete first lead 51, thereby reducing the risk of open circuit and improving the production yield.

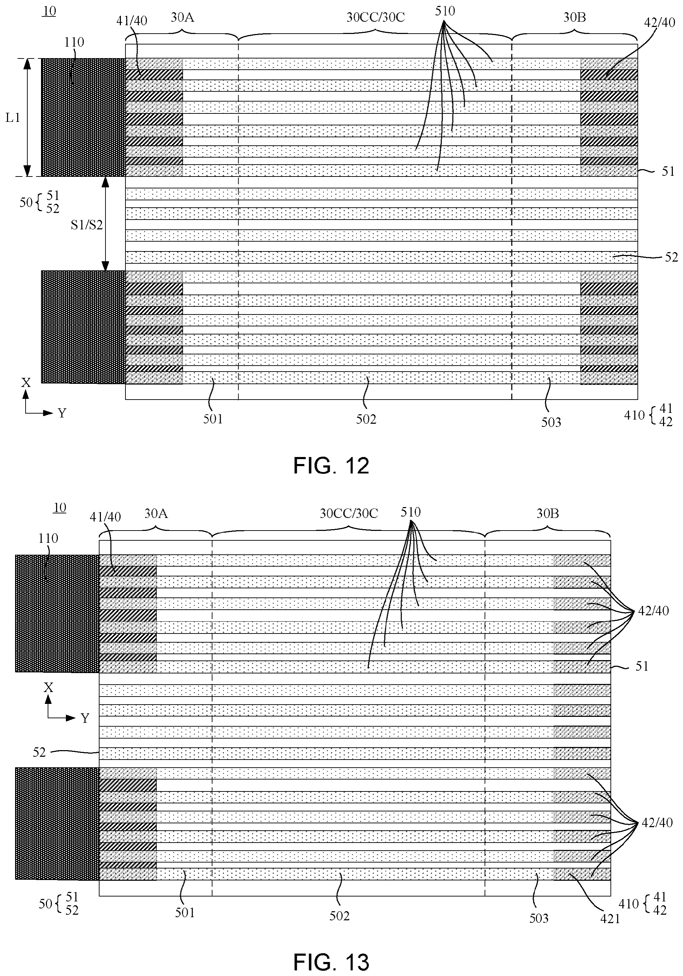

For example, as shown in FIGS. 12 to 15, the plurality of second electrodes 42 are in one-to-one correspondence with the plurality of first electrodes 41, and at least one first electrode 41 is connected to a corresponding second electrode 42 through at least two first leads 51.

In this case, as long as there is a complete lead 50 between the first electrode 41 and the second electrode 42 that are connected, an electrical signal can still be transmitted between the first electrode 41 and the second electrode 42. Thus, the driver circuit board 230 (see FIG. 3) can provide light-emitting signals to the wiring substrate 10. The risk of open circuit between the first electrode 41 and the second electrode 42 that are connected is reduced, and the production yield is improved.

In some embodiments, as shown in FIGS. 9, 10 and 12, an orthographic projection of any first electrode 41 on the substrate 30 at least partially overlaps with an orthographic projection of a corresponding second electrode 42 on the substrate 30.

The substrate 30 includes a first substrate 31 and a second substrate 32, and the first substrate 31 and the second substrate 32 are arranged fixedly and opposite to each other. The first electrodes 41 are disposed on a surface of the first substrate 31 away from the second substrate 32, and the second electrodes 42 are disposed on a surface of the second substrate 32 close to or away from the first substrate 31.

In some examples, as shown in FIG. 9, the first electrodes 41 are disposed on the surface of the first substrate 31 away from the second substrate 32. That is, the first surface 30A is the surface of the first substrate 31 away from the second substrate 32. The second electrodes 42 are disposed on the surface of the second substrate 32 close to the first substrate 31. That is, the second surface 30B is the surface of the second substrate 32 close to the first substrate 31.

Furthermore, the third line segment 503 of the first lead 51 is located between the first substrate 31 and the second substrate 32. The second electrode 42 laps the third line segment 503 of the first lead 51, and is thus connected to the corresponding first electrode 41 through at least two first leads 51.

For example, referring to FIG. 9, the wiring substrate 10 further includes a first line layer 60, and the first line layer 60 is disposed on the first surface 30A of the substrate 30. The first electrodes 41 may be located in the first line layer 60 and connected to signal lines 110 (power signal lines, address signal lines, data signal lines and ground signal lines, etc.) included in the first line layer 60.

It will be noted that the first line layer 60 may be of a single-layer structure or a multi-layer structure, which is not specifically limited in the embodiments of the present disclosure. An end portion of the second electrode 42 away from the selected side surface 30CC may be directly connected to the driver circuit board 230, so as to provide a light-emitting signal to the wiring substrate 10. For example, the second substrate 32 may be made of a material such as polyethylene terephthalate (PET), polyethylene naphthalate (PEN), or polyimide (PI). The second substrate 32 may be a flexible substrate.

In some other examples, as shown in FIG. 10, the first electrodes 41 are disposed on the surface of the first substrate 31 away from the second substrate 32. That is, the first surface 30A is the surface of the first substrate 31 away from the second substrate 32. The second electrodes 42 are disposed on the surface of the second substrate 32 away from the first substrate 31. That is, the second surface 30B is the surface of the second substrate 32 away from the first substrate 31.

Furthermore, the third line segment 503 of the first lead 51 is located on a side of the second substrate 32 away from the first substrate 31. The second electrode 42 laps the third line segment 503 of the first lead 51, and is thus connected to the corresponding first electrode 41 through at least two first leads 51.

For example, referring to FIG. 10, the wiring substrate 10 further includes a first line layer 60 and a second line layer 70. The first line layer 60 is disposed on the first surface 30A of the substrate 30. The first electrodes 41 may be located in the first line layer 60 and connected to signal lines 110 included in the first line layer 60. The second line layer 70 is disposed on the second surface 30B of the substrate 30. The second electrodes 42 may be located in the second line layer 70 and connected to signal lines 110 included in the second line layer 70.

It will be noted that the second line layer 70 may be of a single-layer structure or a multi-layer structure, which is not specifically limited in the embodiments of the present disclosure. The second substrate 32 plays a supporting role. In some embodiments, the second electrode 42 may be connected to the driver circuit board 230 through a flexible circuit board to provide a light-emitting signal to the wiring substrate 10. In some other embodiments, an end portion of the second electrode 42 away from the selected side surface 30CC may be directly connected to the driver circuit board 230, so as to provide a light-emitting signal to the wiring substrate 10. For example, the second substrate 32 may be made of a material such as PET, PEN or PI. For example, the second substrate 32 may be made of a rigid material such as glass, quartz, plastic, or polymethyl methacrylate (PMMA).

In some embodiments, referring to FIGS. 8 to 15, a first electrode 41 and a second electrode 42 that are connected to the same first lead 51 constitute an electrode pair 410. A first electrode 41 and a second electrode 42 in any electrode pair 410 are connected by a first lead group 510, and each first lead group 510 includes at least two first leads 51.

That is to say, any first electrode 41 and a corresponding second electrode 42 are connected through at least two first leads 51. In this way, as long as there is a complete lead 50 between any first electrode 41 and the second electrode 42, an electrical signal can still be transmitted between the first electrode 41 and the second electrode 42. Thus, the driver circuit board 230 can provide light-emitting signals to the wiring substrate 10, the risk of open circuit between the first electrode 41 and the second electrode 42 is reduced, and the production yield is improved.

It will be understood that widths of the first electrode 41 and the second electrode 42 in the first direction X and a distance between the first electrode 41 and the second electrode 42 in the first direction X can be set according to actual conditions.

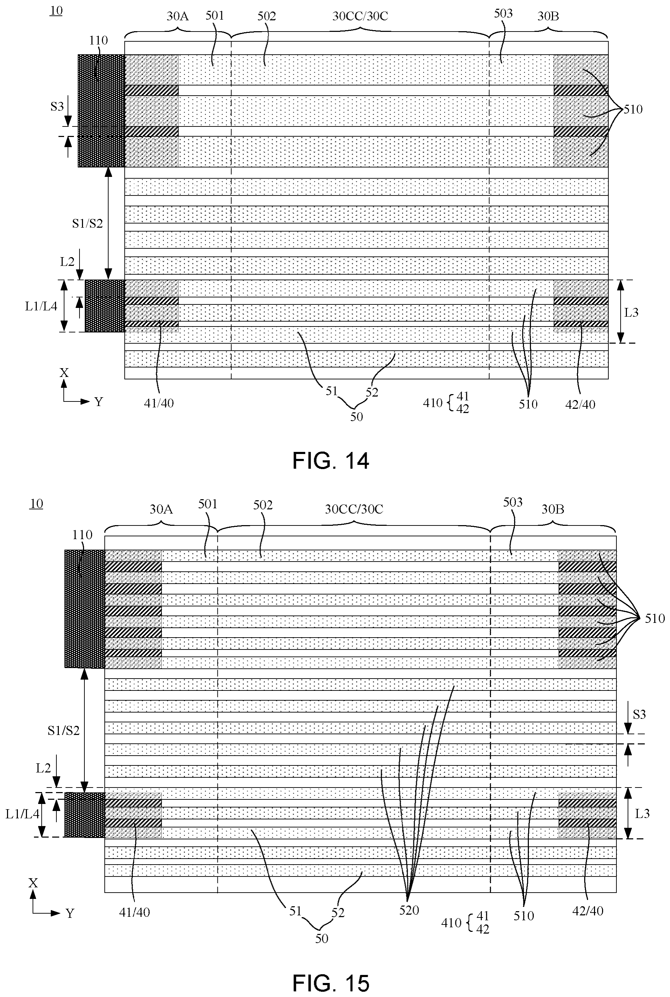

In some embodiments, referring to FIG. 14, a width L1 of the first electrode 41 in the first direction X is positively correlated with a width L2 of a signal line 110 connected to the first electrode 41 in the first direction X. And/or, a distance S1 between two adjacent first electrodes 41 is positively correlated with a distance S2 between signal lines 110 that are respectively connected to the two adjacent first electrodes 41.

In this case, the signal lines 110 are in one-to-one correspondence with the first electrodes 41, which results in a regular structure and facilitates reducing the contact resistance. In addition, the signal lines 110 are in one-to-one correspondence with the first electrodes 41, which facilitates distinguishing signal lines connected to the second electrodes 42, and in turn facilitates the alignment connection between the second electrodes 42 transmitting different signals and the driver circuit board 230.

In some other embodiments, referring to FIG. 12, the width L1 of each first electrode 41 in the first direction X is the same, and/or the distance S1 between two adjacent first electrodes 41 is the same.

In this case, the widths L1 of the plurality of first electrodes 41 in the first direction X may not correspond to a specific signal line 110, so that the manufacturing process is simple and the process difficulty is low. Furthermore, the signal line 110 does not need to be aligned and connected to a specific first electrode 41. Each signal line 110 may be connected to one first electrode 41 or multiple first electrodes 41. The risk of open circuit between the signal line 110 and the first electrode 41 is lower, and the alignment process of the signal line 110 and the first electrode 41 may be omitted, the process flow is simplified, and the production yield is improved.

In some embodiments, referring to FIG. 12, the second electrode 42 is a block electrode. Each first electrode 41 and a corresponding second electrode 42 are connected through a plurality of first leads 51 of a first lead group 510. Here, the width of the first electrode 41 in the first direction X and the width of the second electrode 42 in the first direction X may be approximately equal, for example.

In this case, one first electrode 41 corresponds to one second electrode 42, the structure is regular, and it is conducive to reducing the contact resistance. In addition, each second electrode 42 is independently connected to different signal lines, which facilitates alignment connection with the driver circuit board 230.

In some other embodiments, referring to FIG. 13, each second electrode 42 includes a plurality of sub-electrodes 421. In the first direction X, widths of all the sub-electrodes 421 are approximately the same, and the spacing between all the sub-electrodes 421 is approximately even. Moreover, in the first direction X, the width of the sub-electrode 421 is smaller than the width of any first electrode 41.

In this case, the widths of the plurality of sub-electrodes 421 in the first direction X does not need to correspond to the first electrode 41, and the plurality of sub-electrodes 421 included in each second electrode 42 are connected to one first electrode 41 through a plurality of first leads 51 of one first lead group 510. For example, one sub-electrode 421 is connected to the one first electrode 41 through one first lead 51, and the risk of open circuit between the first electrode 41 and the second electrode 42 is lower.

It will be noted that a part of sub-electrodes 421 among the plurality of sub-electrodes 421 may lap a second lead 52, which is not specifically limited in the embodiments of the present disclosure.

Some embodiments of the present disclosure are schematically described below by taking an example in which the second electrode 42 may be a block electrode, but the embodiments of the present disclosure are not limited thereto.

It can be understood that the widths of the first leads 51 in the first lead group 510 in the first direction X and the distance between the first leads 51 in the first lead group 510 in the first direction X can be set according to actual conditions.

For example, referring to FIGS. 14 and 15, any first lead 51 in each first lead group 510 has the same width L2 in the first direction X. On this basis, as shown in FIG. 15, widths L2, in the first direction X, of all the leads 50 (including the second leads 52) are the same, so as to simplify the manufacturing process.

For example, referring to FIGS. 14 and 15, in each first lead group 510, the distance between any two adjacent first leads 51 in the first direction X is the same. On this basis, as shown in FIG. 15, the distance between all the leads 50 in the first direction X is the same, so as to simplify the manufacturing process.

For example, referring to FIGS. 14 and 15, in each first lead group 510, the width L2 of any first lead 51 in the first direction X is the same; and in each first lead group 510, the distance S3 between any two adjacent first leads 51 in the first direction X is the same. On this basis, as shown in FIG. 15, the widths L2 of all the leads 50 in the first direction X is the same, and the distance S3 between all the leads 50 in the first direction X is the same, so as to simplify the manufacturing process.

In some embodiments, referring to FIGS. 14 and 15, in each first lead group 510, the distance S3 between any two adjacent first leads 51 in the first direction X is less than or equal to the width L2 of any first lead 51 in the first direction X. On this basis, as shown in FIGS. 14 and 15, the distance S3 between all the leads 50 in the first direction X is less than or equal to the width L2 of any lead 50 in the first direction X, so as to simplify the manufacturing process.

The distance between the two adjacent leads 50 is less than or equal to 15 µm. In the case where all the leads 50 are formed using laser etching, since a width of an etching channel formed by a single etching process is small, in order to avoid the distance between two adjacent leads 50 being too large, multiple etching processes are required, resulting in long process time and damage to surfaces of lower film layers (e.g., the substrate 30). For example, the distance between two adjacent leads 50 may be set to any one of 15 µm, 10 µm, 8 µm, 7 µm, 6 µm, 5 µm, 4 µm, 2 µm and 1 µm.

In the first direction, the width of the lead 50 is in a range of 5 µm to 20 µm. For example, the width of the lead 50 is any one of 5 µm, 8 µm, 10 µm, 13 µm, 14 µm, 15 µm, 18 µm, 19 µm and 20 µm.

In some examples, as shown in FIGS. 14 and 15, a ratio of a width L3 of the first lead group 510 in the first direction X to a width L4 of the electrode pair 410 in the first direction X is greater than or equal to 1, and less than or equal to 1.8.

The width L3 of the first lead group 510 in the first direction X refers to a distance between two borders, away from each other, of two farthest first leads 51 among the plurality of first leads 51 included in the first lead group 510. The width L4 of the electrode pair 410 in the first direction X refers to the larger one of the widths, in the first direction X, of the first electrode 41 and the second electrode 42 in the electrode pair 410.

For example, the widths, in the first direction X, of the first electrode 41 and the second electrode 42 are the same, and a ratio of the width L3 of the first lead group 510 in the first direction X to the width L1 of the first electrode 41 in the first direction X is greater than or equal to 1 and less than or equal to 1.8. In this case, orthographic projections, on the substrate 30, of two borders facing to each other of the first electrode 41 and the second electrode 42 in the second direction Y are both located within an orthographic projection of the first lead group 510 on the substrate 30; and a cross section of multiple first leads 51 connected to the first electrode 41 and the second electrode 42 as a whole have a large area, and the resistance is small. It will be noted that the cross section is perpendicular to the second direction Y. Moreover, in the case where all the leads 50 are formed using laser etching, a border of any lead 50 in the second direction Y may be controlled to not overlap with a border of any first electrode 41 in the second direction Y or a border of any second electrode 42 in the second direction Y. That is, in the process of laser etching, the route of the laser may be prevented from overlapping with the border of the first electrode 41 in the second direction Y or the border of the second electrode 42 in the second direction Y, thereby preventing laser damage to edges of the first electrode 41 and the second electrode 42.

In some embodiments, as shown in FIGS. 12 and 14, first leads 51 included in different first lead groups 510 are the same in number.

For example, as shown in FIG. 14, in the first direction X, at least two first electrodes 41 have different widths. For example, the width of the first electrode 41 in the first direction X is positively correlated with a width, in the first direction X, of a signal line connected to the first electrode 41. In this case, in the first direction X, the width of the first lead 51 is positively correlated with the width of a first electrode 41 connected to the first lead 51.

For example, referring to FIG. 14, in the first direction X, the widths of two first electrodes 41 are different, and quantities of first leads 51 included in two first lead groups 510 connected to the two first electrodes 41 are the same.

As shown in FIG. 14, a width of a first lead 51 connected to a first electrode 41 with a larger width is greater than a width of a first lead 51 connected to a first electrode 41 with a smaller width.

For example, as shown in FIG. 12, in the first direction X, the widths of all the first electrodes 41 are the same, and quantities of first leads 51 included in two first lead groups 510 connected to the two first electrodes 41 are the same. In this case, in the first direction X, widths L2 of first leads 51 in all the first lead groups 510 in the first direction X may be the same; and a distance S3 between two adjacent first leads 51 in all the first lead groups 51 may be the same.

In some other embodiments, referring to FIG. 15, a quantity of first leads 51 included in any first lead group 510 is positively correlated with the width L4, in the first direction X, of the electrode pair 410 connected to the first lead group 510.

The width L4 of the electrode pair 410 in the first direction X refers to the larger one of the widths, in the first direction X, of the first electrode 41 and the second electrode 42 in the electrode pair 410.

For example, as shown in FIG. 15, in the first direction X, at least two first electrodes 41 have different widths. For example, the width of the first electrode 41 in the first direction X is positively correlated with the width, in the first direction X, of the signal line 110 connected to the first electrode 41.

For example, referring to FIG. 15, in the first direction X, the widths of two first electrodes 41 are different, and a quantity of first leads 51 included in each first lead group 510 of two first lead groups 510 connected to the two first electrodes 41 is positively correlated with the width L4, in the first direction X, of an electrode pair 410 connected to the first lead group 510.

In this case, a quantity of first leads 51 connected to a first electrode 41 with a larger width is greater than a quantity of first leads 51 connected to a first electrode 41 with a smaller width.

As shown in FIG. 15, one first electrode 41 is connected to six first leads 51, and another first electrode 41 is connected to three first leads 51. The width of the first electrode 41 connected to six first leads 51 is greater than the width of the first electrode 41 connected to three first leads 51.

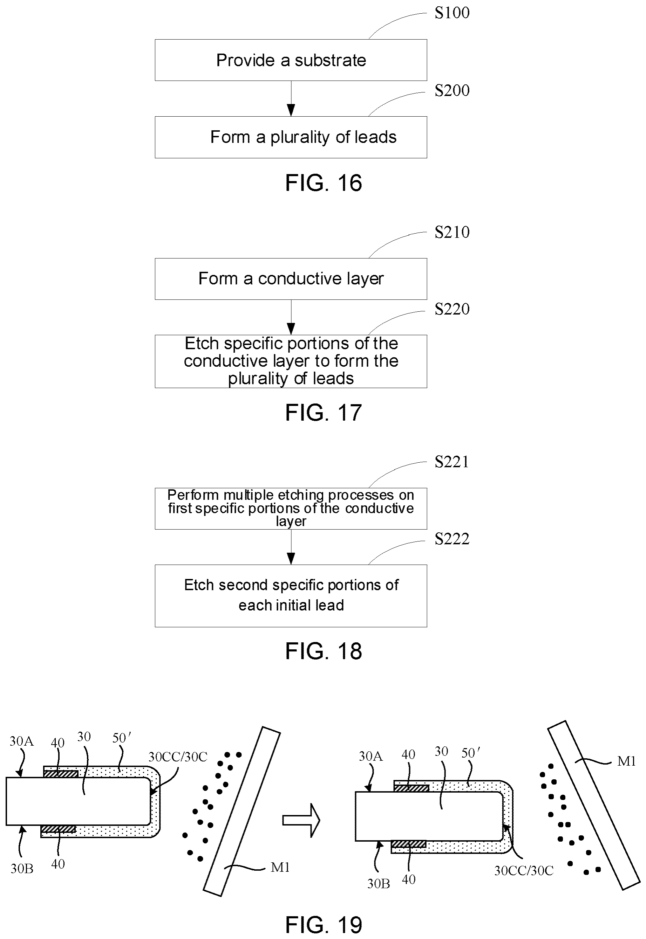

Some embodiments of the present disclosure further provide a method for manufacturing a wiring substrate 10, which is used for manufacturing the wiring substrate 10 as described in any of the above embodiments. As shown in FIG. 16, the method includes S100 to S200.

In S100, a substrate is provided.

In the above step, referring to FIGS. 19 to 21, the substrate 30 has a first surface 30A and a second surface 30B that are opposite to each other, and a plurality of side surfaces 30C connecting the first surface 30A and the second surface 30B. Among the plurality of side surfaces 30C, at least one side surface 30C is a selected side surface 30CC.

In addition, referring to FIGS. 19 to 21, the first surface 30A of the substrate 30 includes a plurality of electrodes 40 arranged at intervals in the first direction X; and/or the second surface 30B of the substrate 30 includes a plurality of electrodes 40 arranged at intervals in the first direction X.

In S200, a plurality of leads are formed.

In the above step, referring to FIGS. 11 to 15, the plurality of leads 50 are arranged at intervals in the first direction X. Each lead 50 includes a first line segment 501, a second line segment 502, and a third line segment 503 that are connected in sequence. The first line segment 501 is located on the first surface 30A, the second line segment 502 is located on the selected side surface 30CC, and the third line segment 503 is located on the second surface 30B.

In addition, referring to FIGS. 11 to 15, the plurality of leads 50 include a plurality of first leads 51 and a plurality of second leads 52, and at least one electrode 40 laps at least two first leads 51. The plurality of second leads 52 are insulated from the electrodes 40. Furthermore, on the first surface 30A or the second surface 30B of the substrate 30, at least one second lead 52 exists between two adjacent first leads 51 connected to different electrodes 50.

It will be understood that the process method used in the above S200 varies. S200 may use a sputtering process and a laser etching process; or S200 may use a mask and a sputtering process; or S200 may use a printing process and a transfer printing process; or S200 may use at least one of selective laser melting and electron beam selective melting after film formation.

Some embodiments of the present disclosure are illustrated below by taking an example in which S200 uses a sputtering process and a laser etching process. However, the embodiments of the present disclosure are not limited thereto, and any other process method may also be considered as long as the same technical ideas are applied.

For example, referring to FIG. 17, the above S200 includes S210 to S220.

In S210, a conductive layer is formed.

In the above step, referring to FIGS. 19 to 21, the conductive layer 50' covers the selected side surface 30CC of the substrate 30 and extends to the first surface 30A and the second surface 30B.

For example, referring to FIGS. 12 and 19, the first surface 30A of the substrate 30 is provided with a plurality of electrodes 40 arranged at intervals in the first direction X, and the second surface 30B of the substrate 30 is provided with a plurality of electrodes 40 arranged at intervals in the first direction X. In this case, on the first surface 30A, the conductive layer 50' at least extends to one side of the electrode 40 and laps the electrode 40; and on the second surface 30B, the conductive layer 50' at least extends to one side of the electrode 40 and laps the electrode 40.

In some examples, referring to FIG. 19, the above S210 specifically includes: bombarding a first target M1 using inert gas.

In the above step, referring to FIG. 19, the first target M1 swings between a first position and a second position. An angle between the first target M1 at the first position and a plane where the second surface 30B is located is approximately equal to an angle between the first target M1 at the second position and the plane where the second surface 30B is located. The angle between the first target M1 at the first position and the plane where the second surface 30B is located is greater than or equal to 75°.

It will be noted that the inert gas includes any one of helium, neon, and argon, which will not be specifically limited in the embodiments of the present disclosure.

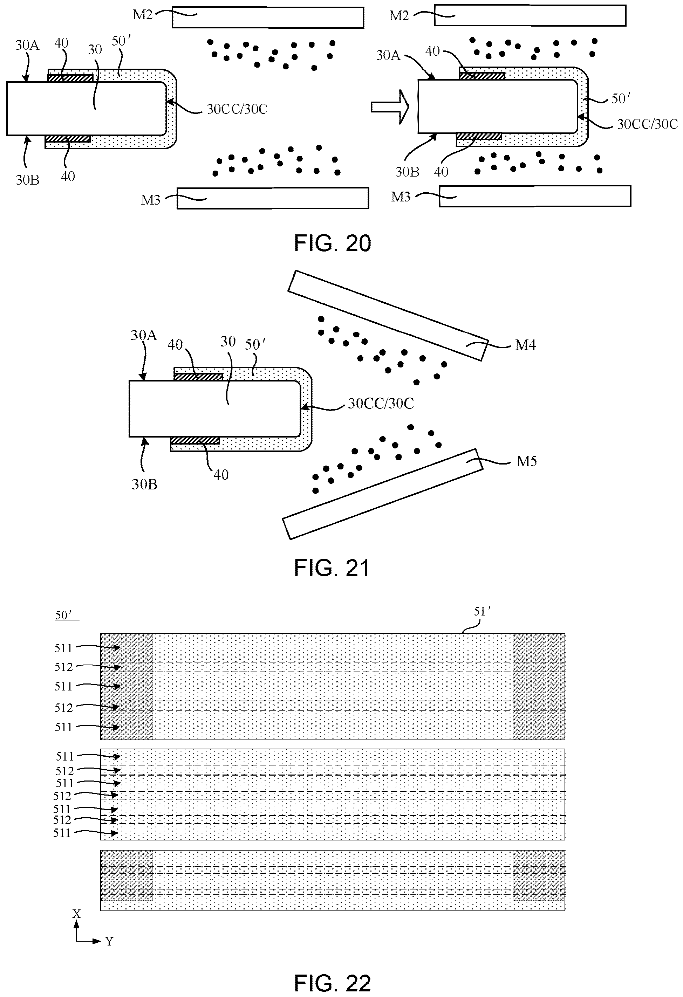

In some other examples, referring to FIG. 20, S210 specifically includes: bombarding a second target M2 and a third target M3 using inert gas, the substrate 30 moving at a non-uniform speed between the second target M2 and the third target M3.

In the above step, referring to FIG. 20, the second target M2 and the third target M3 are located on two opposite sides of the substrate 30, and are approximately parallel to the second surface 30B of the substrate 30.

In some other examples, referring to FIG. 21, S210 specifically includes: bombarding a fourth target M4 and a fifth target M5 using inert gas.

In the above step, referring to FIG. 21, the fourth target M4 and the fifth target M5 are located on two opposite sides of the substrate 30, and are tilted relative to the substrate 30. For example, an angle between the fourth target M4 and the plane where the second surface 30B is located is in a range of 10° to 30°, and an angle between the fifth target M5 and the plane where the second surface 30B is located is in a range of 10° to 30°.

Herein, the materials of the first target M1, the second target M2, the third target M3, the fourth target M4 and the fifth target M5 may be the same material or different. The materials of the first target M1, the second target M2, the third target M3, the fourth target M4 and the fifth target M5 each include a conductive material. In some embodiments, the conductive material includes a metal element or an alloy, e.g., at least one of copper, aluminum, nickel, chromium, gold, or silver. In some other embodiments, the conductive material includes nonmetal, e.g., carbon and/or silicon. In yet some other embodiments, the conductive material includes metallic oxide, e.g., aluminum oxide and/or indium tin oxide.

In S220, specific portions of the conductive layer are etched to form the plurality of leads.

In the above step, multiple etching processes are performed on specific portions of the conductive layer 50', and portions of the conductive layer 50' that are not etched form the plurality of leads 50. An etching order of performing multiple etching processes includes at least one of: performing multiple etching processes sequentially from one side to another side of the conductive layer 50', performing multiple etching processes alternately from the middle to two sides of the conductive layer 50', or performing multiple etching processes alternately from two sides to the middle of the conductive layer 50'. It will be noted that the etching process may be a laser etching process.

It will be noted that the specific portions are preset portions, which are portions between the plurality of leads 50 that are finally formed, which can be specifically set according to actual conditions.

In addition, in the first direction X and from a first side to a second side of the conductive layer 50', the multiple etching processes are a first etching to an Nth etching in sequence. The first side and the second side are two opposite sides of the conductive layer 50' in the first direction X.

For example, the etching order may be the first etching, a second etching, a third etching, a fourth etching, ..., an (N - 1)th etching, and the Nth etching.

In this case, the multiple etching processes are performed sequentially from the first side to the second side, resulting in low process difficulty and high production efficiency.

For another example, the etching order may be: the first etching, the Nth etching, the second etching, the (N - 1)th etching, ..., an (N / 2 + 1)th etching, and an (N / 2)th etching.

In this case, the multiple etching processes are performed alternately from two sides to the middle of the conductive layer 50', resulting in a low risk of residual melting liquid droplets between two adjacent leads 50 and a low risk of short circuit between two adjacent leads 50.

For yet another example, the etching order may be: the first etching, the second etching, ..., the (N / 2)th etching, the Nth etching, the (N - 1)th etching, ..., and the (N / 2 + 1)th etching. Alternatively, the etching order may be: the (N / 2)th etching, an (N / 2 - 1)th etching, ..., the first etching, the (N / 2 + 1)th etching, an (N / 2 + 2)th etching, ..., and the Nth etching.

In this case, performing multiple etching processes are divided into two phases, one phase is performed sequentially from the first side to the second side, and the other phase is performed sequentially from the second side to the first side, resulting in a low risk of residual melting liquid droplets between two adjacent leads 50 and a low risk of short circuit between two adjacent leads 50.

In some embodiments, referring to FIG. 18, S220 includes S221 to S222.

In S221, multiple etching processes are performed on first specific portions of the conductive layer.

In the above step, referring to FIG. 22, portions of the conductive layer 50' that are not etched form a plurality of initial leads 51'. An etching order of performing multiple etching processes includes at least one of: performing multiple etching processes sequentially from one side to another side of the conductive layer 50', performing multiple etching processes alternately from the middle to two sides of the conductive layer 50', or performing multiple etching processes alternately from two sides to the middle of the conductive layer 50'.

The initial lead 51' includes lead portions 511 and interval portions 512. The lead portions 511 and the interval portions 512 extend in the second direction Y and are staggered in the first direction X.

For example, referring to FIGS. 15 and 22, a border of a part of the initial leads 51' in the second direction Y is a border of a first lead group 510 to be formed in the second direction Y; a border of another part of the initial leads 51' in the second direction Y is a border of a second lead group 520 formed by multiple second leads 52 between adjacent first lead groups 510 in the second direction Y. The first specific portion is a portion between a first lead group 510 and a second lead group 520.

It will be noted that as for the etching order of performing multiple etching processes here, reference can be made to the above description, and details are not repeated in the embodiments of the present disclosure.

In S222, second specific portions of each initial lead are etched.

In the above step, referring to FIG. 22, portions of the initial leads 51' (lead portions 511) form a plurality of leads 50 (see FIG. 15).

The first specific portions and the second specific portions may be set according to actual conditions. The first specific portions and the second specific portions are all portions that need to be etched.

For example, referring to FIGS. 15 and 22, a first specific portion is a portion between a first lead group 510 and a second lead group 520, and the second specific portions are the interval portions 512 in the first lead groups 510 and the second lead groups 520.

For example, in the first direction X and from a first side to a second side of the conductive layer 50', the multiple etching processes are a first etching to an Nth etching in sequence. The first side and the second side are two opposite sides of the conductive layer 50' in the first direction X.

In this case, the first specific portions may be, for example, portions etched odd-numbered times, and the second specific portions may be, for example, portions etched even-numbered times. Alternatively, the first specific portions may be, for example, portions etched odd-numbered times, and the second specific portions may be, for example, portions etched even-numbered times, which is not specifically limited in the embodiments of the present disclosure.

In the description of the present specification, specific features, structures, materials or characteristics may be combined in any one or more embodiments or examples in a suitable manner.

The foregoing descriptions are merely specific implementations of the present disclosure, but the protection scope of the present disclosure is not limited thereto. Any changes or replacements that a person skilled in the art could conceive of within the technical scope of the present disclosure shall be included in the protection scope of the present disclosure. Therefore, the protection scope of the present disclosure should be determined by the protection scope of the claims.

## Claims

1. A wiring substrate, comprising:
a substrate having a first surface and a second surface that are opposite to each other and a plurality of side surfaces connecting the first surface and the second surface, wherein at least one side surface among the plurality of side surfaces is a selected side surface;
a plurality of electrodes being arranged at intervals in a first direction on the first surface of the substrate and/or being arranged at intervals in the first direction on the second surface of the substrate; and
a plurality of leads arranged at intervals in the first direction, wherein each lead includes a first line segment, a second line segment and a third line segment that are connected in sequence; the first line segment is located on the first surface, the second line segment is located on the selected side surface, and the third line segment is located on the second surface; the plurality of leads include a plurality of first leads and a plurality of second leads; at least one of the electrodes laps at least two of the first leads; the plurality of second leads are insulated from the electrodes; and on the first surface or the second surface of the substrate, at least one second lead exists between two adjacent first leads connected to different electrodes.

2. The wiring substrate according to claim 1, wherein the plurality of electrodes include:
a plurality of first electrodes arranged at intervals in the first direction on the first surface of the substrate; and
a plurality of second electrodes being arranged at intervals in the first direction on the second surface of the substrate and being in one-to-one correspondence with the plurality of first electrodes, wherein at least one of the first electrodes and a corresponding second electrode are connected through at least two of the first leads.

3. The wiring substrate according to claim 2, wherein an orthographic projection of any one of the first electrodes on the substrate at least partially overlaps with an orthographic projection of a corresponding second electrode on the substrate;
the substrate includes a first substrate and a second substrate; the first substrate and the second substrate are arranged fixedly and opposite to each other; the first electrodes are arranged on a surface of the first substrate away from the second substrate;
and the second electrodes are arranged on a surface of the second substrate close to or away from the first substrate.

4. The wiring substrate according to claim 2 or 3, wherein a first electrode and a second electrode that are connected to a same first lead constitute an electrode pair; a first electrode and a second electrode in any one electrode pair are connected by a first lead group; and each first lead group includes at least two first leads.

5. The wiring substrate according to claim 4, wherein a ratio of a width of the first lead group in the first direction to a width of the electrode pair in the first direction is greater than or equal to 1 and less than or equal to 1.8.

6. The wiring substrate according to claim 4 or 5, wherein quantities of first leads included in different first lead groups are the same.

7. The wiring substrate according to claim 4 or 5, wherein a quantity of first leads included in any one first lead group is positively correlated with a width, in the first direction, of an electrode pair connected to the any one first lead group.

8. The wiring substrate according to any one of claims 4 to 7, wherein widths, in the first direction, of first leads in all first lead groups are the same; and/or a distance between two adjacent first leads in all the first lead groups is the same.

9. The wiring substrate according to any one of claims 4 to 8, wherein in each first lead group, a distance between any two adjacent first leads in the first direction is less than or equal to a width of any one first lead in the first direction.

10. The wiring substrate according to any one of claims 1 to 9, wherein a distance between any two adjacent leads in the first direction is the same; and/or a width of any one lead in the first direction is the same.

11. The wiring substrate according to any one of claims 1 to 10, wherein a distance between any two adjacent leads in the first direction is less than or equal to a width of any one lead in the first direction.

12. A display apparatus, comprising:
the wiring substrate according to any one of claims 1 to 11;
electronic components disposed on the first surface of the substrate of the wiring substrate; and
a driver circuit board connected to the wiring substrate.

13. A method for manufacturing a wiring substrate, used for manufacturing the wiring substrate according to any one of claims 1 to 11, the method comprising:
providing the substrate, wherein the substrate has a first surface and a second surface that are opposite to each other and a plurality of side surfaces connecting the first surface and the second surface; at least one side surface among the plurality of side surfaces is a selected side surface; the first surface of the substrate is provided with a plurality of electrodes arranged at intervals in a first direction, and/or the second surface of the substrate is provided with a plurality of electrodes arranged at intervals in a first direction; and
forming the plurality of leads, wherein the plurality of leads are arranged at intervals in the first direction; each lead includes a first line segment, a second line segment and a third line segment that are connected in sequence; the first line segment is located on the first surface, the second line segment is located on the selected side surface, and the third line segment is located on the second surface; the plurality of leads include a plurality of first leads and a plurality of second leads; at least one of the electrodes laps at least two of the first leads; the plurality of second leads are insulated from the electrodes; and on the first surface or the second surface of the substrate, at least one second lead exists between two adjacent first leads connected to different electrodes.

14. The method according to claim 13, wherein forming the plurality of leads includes:
forming a conductive layer, the conductive layer covering the selected side surface of the substrate and extending to the first surface and the second surface; and
performing multiple etching processes on specific portions of the conductive layer, wherein portions of the conductive layer that are not etched form the plurality of leads.

15. The method according to claim 14, wherein performing multiple etching processes on the specific portions of the conductive layer includes:
performing multiple etching processes on first specific portions of the conductive layer, wherein portions of the conductive layer that are not etched form a plurality of initial leads; and
etching second specific portions of each of the initial leads, wherein portions of the initial leads that are not etched form the plurality of leads.

16. The method according to claim 14 or 15, wherein an etching order of performing multiple etching processes includes at least one of: performing multiple etching processes sequentially from one side to another side of the conductive layer, performing multiple etching processes alternately from a middle to two sides of the conductive layer, or performing multiple etching processes alternately from the two sides to the middle of the conductive layer.
